# DEMANDE DE BREVET EUROPEEN

(11) **EP 4 761 013 A2**
(43) Date de publication de la demande: **17.06.2026**
(21) Numéro de dépôt: 25220797.2
(22) Date de dépôt: 04.12.2025
(51) Int. Cl.: H01S 5/04, H01S 5/06

(54) **SOURCE LUMINEUSE DIRECTEMENT MODULÉE**

(30) Priorité: 12.12.2024 FR 2413946
(71) Demandeur: Commissariat à l'Energie Atomique et aux Energies Alternatives, 75015 Paris (FR)
(72) Inventeur: RAMIREZ, Joan, 91767 PALAISEAU (FR); BESANCON, Claire, 91767 PALAISEAU (FR)
(74) Mandataire: Atout PI Laplace

(57) **Abrégé**

L'invention concerne une source lumineuse directement modulée (DMD) comprenant :
- une diode laser dite horizontale (DH) comprenant une jonction PIN horizontale (JH), la jonction horizontale étant formée d'une zone intrinsèque (Zi) disposée entre une première zone dopée p (Zp1) et une première zone dopée n (Zn1), la zone intrinsèque comprenant des puits quantiques ;
- une jonction PIN verticale (JV) formée de ladite zone intrinsèque disposée entre une deuxième zone dopée p (Zp2), et une deuxième zone dopée n (Zn2) disposée du côté du substrat ;
la jonction verticale étant polarisée en inverse et module ladite lumière émise par la diode laser horizontale par effet Stark dans les puits quantique ;
- une couche bloquante (CB) disposée sous la première zone dopée p et configurée pour empêcher des fuites de courant entre la première zone dopée de type p et la deuxième zone dopée n.

## Description

### DOMAINE TECHNIQUE

L'invention concerne une source lumineuse directement modulée, et en particulier une source lumineuse directement modulée utilisant l'effet Stark.

### ARRIÈRE-PLAN

Les lasers directement modulés de l'état de la technique contiennent des diodes laser dont le courant d'injection est modulé via un signal électronique analogique. Afin de générer des zéros optiques, l'injection doit donc être discontinue, c'est-à-dire, alterner entre 0 et une valeur de courant électrique prédéterminée.

Cette discontinuité de l'injection de courant électrique engendre des changements de densité de porteurs dans la bande de conduction ainsi que de température d'opération de la diode, dus à l'échauffement par effet Joule causé par l'injection du courant. Ces phénomènes, qui entrainent le changement de l'indice du matériau actif de la diode laser, entrainent des « chirps » (c'est-à-dire un signal dans lequel la fréquence augmente ou diminue avec le temps) et limitent la bande passante à quelques dizaines de GHz. Il est possible d'améliorer la distance de transmission de la fibre en utilisant des résonateurs annulaires externes. Cependant, de tels dispositifs prennent en compte deux signaux de commande (un pour le laser et un pour le modulateur), ont une sensibilité à la température plus élevée et sont sujets à des non-linéarités dans l'anneau à partir d'une puissance optique couplée moyenne-élevée, ce qui entraîne une distorsion du signal.

Afin de limiter ces inconvénients, il est possible d'utiliser un laser à modulation externe. Dans un laser à modulation externe, contrairement au laser directement modulé, le courant est injecté en continu dans la diode laser et des modulateurs (typiquement des diodes également) sont utilisés pour moduler le signal optique venant du laser par le biais d'un voltage en inverse. Ce voltage induit un courant dans les modulateurs (typiquement celui d'une diode III-V PIN en inverse) qui est plus faible par rapport à ce qui est injecté dans la diode. Il n'y a donc pas de changement de température majeur, et donc pas de changement majeur d'indice de réfraction du matériau actif de la diode, réduisant ainsi le chirp. C'est ainsi que les lasers à modulation externe permettent des liaisons optiques sur des distances supérieures à 10 km.

Cependant, les modulateurs par électroabsorption utilisés pour la modulation externe nécessitent deux drivers et ils produisent une puissance modulée inférieure à celle des lasers à modulation direct, due à la perte d'insertion dans le modulateur d'électroabsorption. Aussi, les lasers à modulation externe peuvent être difficile à mettre en place puisqu'il faut éviter de saturer l'entrée du modulateur afin d'éviter de dégrader l'amplitude de modulation optique. Idéalement, le modulateur par électroabsorption devrait fonctionner en régime linéaire et devrait avoir une bande interdite de matériau différente afin de minimiser les pertes d'insertion. De telles exigences impliquent une technologie de fabrication complexe et coûteuse avec un étalonnage de bande interdite précis par rapport aux lasers directement modulés.

### RÉSUMÉ

Afin de pallier les inconvénients précités des diodes lasers, l'invention propose une source lumineuse directement modulée comprenant :
- une diode laser dite horizontale comprenant un substrat et une première jonction PIN dite horizontale s'étendant selon un axe X d'un repère XYZ définissant un plan horizontal XY parallèle audit substrat et un axe vertical Z, la première jonction PIN étant formée d'une zone intrinsèque disposée entre une première zone dopée de type p et une première zone dopée de type n, la zone intrinsèque comprenant un empilement de puits quantiques disposés perpendiculairement à l'axe Z ;
   la diode laser horizontale étant destinée à être polarisée en direct et configurée pour émettre de la lumière selon l'axe Y lorsqu'un courant électrique continu est injecté dans la jonction horizontale ;
- une deuxième jonction PIN dite verticale s'étendant selon l'axe Z et formée de ladite zone intrinsèque disposée entre une deuxième zone dopée de type p, et une deuxième zone dopée de type n disposée du côté du substrat ;
   la jonction verticale étant destinée à être polarisée en inverse et configurée pour moduler ladite lumière émise par la diode laser horizontale lorsqu'un champ électrique alternatif selon l'axe Z est appliqué à ladite zone intrinsèque, ladite modulation s'opérant par effet Stark dans les puits quantique ; et
- une couche bloquante disposée au moins sous la première zone dopée de type p et configurée pour empêcher des fuites de courant entre la première zone dopée de type p et la deuxième zone dopée de type n.

Dans un mode de réalisation, la couche bloquante est en matériau isolant ou semi isolant.

Dans un mode de réalisation, le matériau est de l'InP semi-isolant.

Dans un mode de réalisation, la couche bloquante comprend une troisième zone de type p et une troisième zone de type n formant une diode configurée pour être polarisée en inverse.

Dans un mode de réalisation, la zone intrinsèque de la diode laser horizontale est couplée optiquement à un réseau de rétroaction répartie.

Dans un mode de réalisation, le substrat est en matériau InP ou GaAs.

Dans un mode de réalisation, la source lumineuse directement modulée comprend en outre une couche semi-isolante en matériau cristallin disposée sur le substrat et en contact avec la couche bloquante et la deuxième zone dopée de type n.

Dans un mode de réalisation, le substrat et la couche semi-isolante sont en matériau InP.

La description suivante présente plusieurs exemples de réalisation du dispositif de l'invention: ces exemples sont non limitatifs de la portée de l'invention. Ces exemples de réalisation présentent à la fois les caractéristiques essentielles de l'invention ainsi que des caractéristiques additionnelles liées aux modes de réalisation considérés.

### BRÈVE DESCRIPTION DES DESSINS

L'invention sera mieux comprise et d'autres avantages apparaîtront à la lecture de la description qui va suivre donnée à titre non limitatif et grâce aux figures parmi lesquelles :
[Fig.1a] la figure 1a illustre une source lumineuse directement modulée selon l'invention, vue en coupe;
[Fig.1b] la figure 1b illustre une source lumineuse directement modulée selon l'invention, vue du dessus ;
[Fig. 2a] la figure 2a illustre un exemple de source lumineuse directement modulée, vue en coupe ;
[Fig. 2b] la figure 2b illustre un autre exemple de source lumineuse directement modulée, vue en coupe ; et
[Fig. 3] la figure 3 illustre un schéma électrique équivalent d'une source lumineuse directement modulée selon l'invention.

### DESCRIPTION DÉTAILLÉE

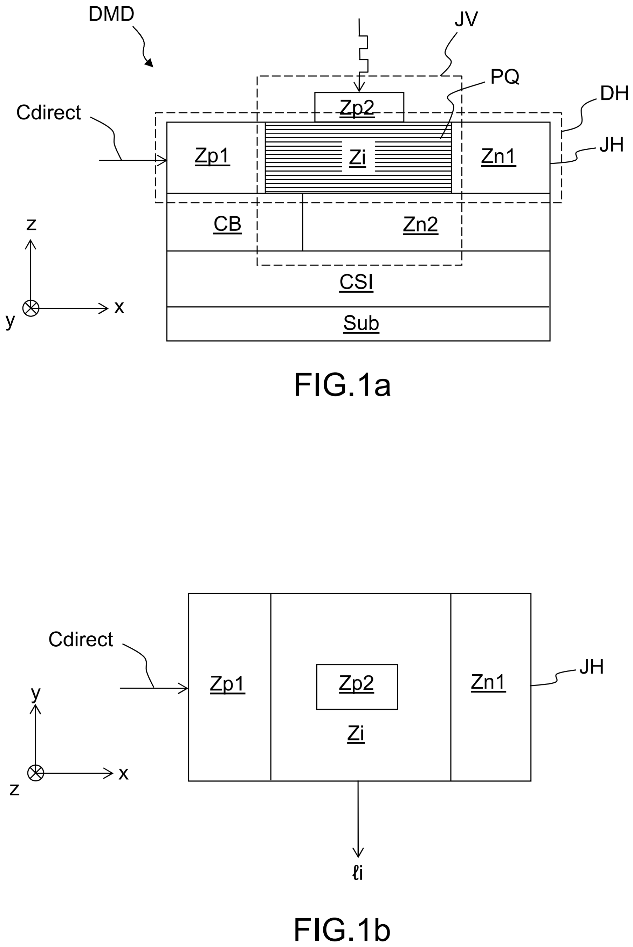

L'invention concerne une source lumineuse directement modulée. La figure 1a et la figure 1b illustrent une source lumineuse directement modulée DMD selon l'invention, vue en coupe et vue du dessus, respectivement.

La source lumineuse directement modulée DMD comprend une diode laser dite horizontale DH comprenant un substrat Sub et une première jonction PIN dite horizontale JH s'étendant selon un axe X d'un repère XYZ définissant un plan horizontal XY parallèle au substrat et un axe vertical Z. La première jonction PIN est formée d'une zone intrinsèque Zi disposée entre une première zone dopée de type p Zp1 et une première zone dopée de type n Zn1, la zone intrinsèque Zi comprenant un empilement de puits quantiques PQ disposés perpendiculairement à l'axe Z. La zone Zi constitue la zone active de la diode laser DH.

La diode laser horizontale DH est destinée à être polarisée en direct et est configurée pour émettre de la lumière li selon l'axe Y lorsqu'un courant électrique continu Cdirect est injecté dans la jonction horizontale JH. A titre d'exemple, un générateur de courant continu DCV injecte un courant électrique continu Cdirect dans la jonction horizontale JH. Le courant est injecté de façon latérale par rapport aux puits quantiques PQ. Typiquement, le courant continu Cdirect est généré avec un générateur de courant continu DCV.

La source lumineuse directement modulée DMD comprend également une deuxième jonction PIN dite verticale JV s'étendant selon l'axe Z et formée de la zone intrinsèque Zi disposée entre une deuxième zone dopée de type p Zp2 et une deuxième zone dopée de type n Zn2. La deuxième zone dopée de type n Zn2 est disposée entre la zone intrinsèque Zi et le substrat. Ainsi, la jonction horizontale JH et la jonction verticales JV ont la même zone intrinsèque Zi.

La jonction verticale JV est destinée à être polarisée en inverse et est configurée pour moduler la lumière li émise par la diode laser horizontale DH lorsqu'un champ électrique alternatif selon l'axe Z est appliqué à la zone intrinsèque Zi. La modulation s'opère par effet Stark à confinement quantique dans les puits quantiques PQ de la zone active.

A titre d'exemple, un générateur de tension en créneau ACV injecte une tension en créneau dans la jonction verticale JV, produisant ainsi un champ électrique perpendiculaire aux puits quantiques. La jonction verticale étant polarisée en inverse, très peu de courant est injecté via la jonction JV, et l'injection de porteurs dans la jonction JH n'est pas perturbée.

De plus, la source lumineuse directement modulée DMD comprend une couche bloquante CB disposée au moins sous la première zone dopée de type p Zp1 et configurée pour empêcher des fuites de courant entre la première zone dopée de type p Zp1 et la deuxième zone dopée de type n Zn2. La largeur selon l'axe X de la couche bloquante CB est supérieure à celle de la zone dopée de type p Zp1. En d'autres termes, la couche bloquante CB est disposée de manière à empêcher la première zone dopée de type p Zp1 et la deuxième zone dopée de type n Zn2 d'être en contact.

Les puits quantiques sont configurés pour être modulés par effet Stark à confinement quantique. En particulier, dans l'invention, l'effet Stark à confinement quantique est produit lorsqu'un champ électrique est appliqué de façon perpendiculaire aux puits quantiques.

De manière générale, l'effet Stark se produit lorsqu'un atome ou une molécule est placé dans un champ électrique externe. Le champ électrique interagit avec les particules chargées à l'intérieur de l'atome ou de la molécule, provoquant une division des niveaux d'énergie. La force du champ électrique détermine l'ampleur de la division. En l'absence de confinement, cet effet est difficilement exploitable car les fonctions d'onde de l'électron et du trou s'éloignent très rapidement. Dans l'effet Stark à confinement quantique, les fonctions d'onde sont confinées dans les puits quantiques, la superposition des états modifiés par le champ électrique est améliorée et on observe une réduction instantanée de la bande interdite des puits quantiques (Miller et. al, Band edge electroabsorption in quantum well structures : the quantum-confined Stark effect, Phys. Rev. Lett. 53, 22, 1984).

Dans la présente invention, lorsqu'une tension alternative en créneau (comme représenté sur la figure 1a) qui oscille entre deux valeurs prédéterminées est appliquée aux puits quantiques, un champ électrique perpendiculaire aux puits quantiques est généré. Sous l'action du champ électrique, l'état électronique des puits quantiques est modifié. Ainsi, la bande interdite des puits quantiques est réduite rapidement, grâce à l'effet Stark à confinement quantique. Cela permet de moduler la lumière li émise par la diode horizontale DH, en absorbant ou en laissant passer la lumière li qui est transmise à travers les puits quantiques. La lumière li est donc modulée directement en utilisant l'effet Stark à confinement quantique, à l'intérieur de la source lumineuse DMD. La modulation du champ électrique, à travers la jonction verticale, dans la zone intrinsèque Zi permet donc de moduler la lumière li émise par la diode horizontale DH. Typiquement la tension alternative est produite par un générateur de tension en créneau ACV.

L'invention permet ainsi d'obtenir une source lumineuse directement modulée DMD utilisant l'effet Stark à confinement quantique, qui peut être intégrée dans une source laser. Avantageusement, l'utilisation de l'effet Stark à confinement quantique directement dans la source lumineuse permet d'utiliser une injection de courant continue et constante dans la diode laser horizontale DH tout en ayant une modulation en intensité efficace grâce au champ électrique vertical, le tout dans un seul composant. Le courant continu évite les changements d'indice de réfraction normalement engendrés par un courant injecté de façon discontinue (comme c'est le cas pour les lasers directement modulés de l'état de la technique). Le courant continu permet ainsi de réduire le chirp normalement généré dans les lasers directement modulés de l'état de la technique.

De plus, l'utilisation de l'effet Stark à confinement quantique directement dans la source lumineuse permet une fabrication et une conception simplifiée, sans modulateurs externes, contrairement aux lasers à modulation externe. Ainsi, la présente invention permet d'obtenir une source laser simple, à coût réduits, et avec un chirp réduit.

Le laser directement modulé selon l'invention ne présente donc pas les inconvénients des lasers directement modulés selon l'état de la technique, tout en conservant les avantages, tels qu'une simplicité de fabrication et de conception, un faible coût et une puissance élevée.

Dans un mode de réalisation, le substrat Sub est en matériau InP ou GaAs. Avantageusement, les différentes couches de la source lumineuse DMD sont réalisées par épitaxie à partir du substrat. Ainsi un substrat en InP ou GaAs permet la croissance par épitaxie des puits quantiques PQ directement sur le substrat Sub.

Le choix du substrat et des couches associées dépend de la longueur d'onde d'émission souhaitée. Un substrat en InP permet la mise en œuvre de la source lumineuse DMD à une longueur d'onde de télécommunication, c'est à dire à des longueurs d'ondes supérieures à 1 µm.

Dans un autre mode de réalisation, le substrat Sub est disposé sur un second substrat en silicium, permettant ainsi l'utilisation de la source lumineuse DMD dans une puce par exemple.

La diode laser horizontale DH comprend une cavité optique qui permet d'émettre la lumière li selon l'axe Y lorsqu'un courant électrique continu Cdirect est injecté dans la jonction horizontale JH. Dans un mode de réalisation, la cavité optique peut être définie par le biais de deux miroirs de type réflecteur de Bragg distribué (Distributed Bragg Reflector ou DBR, en anglais), par facette (c'est-à-dire par clivage du composant pour exposer une facette qui est traitée par traitement anti-reflet dont les épaisseurs des matériaux déposés sont ajustés de manière à obtenir un coefficient de réflexion défini) ou en utilisant un résonateur s'étendant selon l'axe Y. La cavité optique peut aussi être définie par un réseau de rétroaction répartie (Distributed-Feedback DFB, en anglais) dans un matériau III-V ou dans un guide optique constitué d'un autre matériau (silicium, nitrure de silicium, niobate de lithium ou autre), s'étendant selon l'axe Y. La zone intrinsèque Zi de la diode laser horizontale DH est ainsi couplée optiquement au réseau de rétroaction répartie DFB.

Avantageusement, le réseau de Bragg de rétroaction répartie DFB permet d'obtenir une émission laser monomode utile pour les communications optiques.

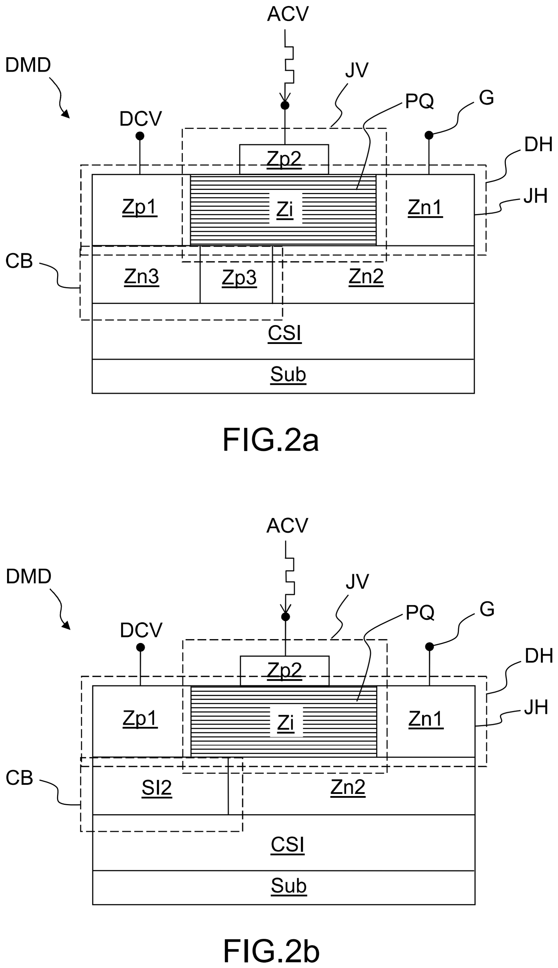

Dans un mode de réalisation illustré dans la figure 2a, la couche bloquante CB comprend une troisième zone de type p Zp3 et une troisième zone de type n Zn3 formant une diode DI configurée pour être polarisée en inverse. Avantageusement, la troisième zone de type p Zp3 est en contact avec la deuxième zone de type n Zn2, de manière à ce que la deuxième zone de type n Zn2 ne soit pas en contact avec la première zone de type n Zn1, empêchant ainsi le courant de passer de la première zone dopée de type p Zp1 à la deuxième zone dopée de type n Zn2. Avantageusement, la diode polarisée en inverse permet d'avoir une couche bloquante d'épaisseur fine.

Dans un autre mode de réalisation illustré dans la figure 2b, la couche bloquante CB est en matériau isolant ou semi isolant SI2. Par exemple, le matériau est de l'InP semi isolant. Avantageusement, la couche en InP semi isolant a une largeur supérieure à la largeur de la zone dopée de type p Zp1.

Dans un mode de réalisation, la structure cristalline de la couche bloquante CB permet la croissance par épitaxie de couches disposées au-dessus de la couche bloquante, et notamment la première zone dopée de type p Zp1.

Dans un mode de réalisation, la source lumineuse directement modulée DMD comprend en outre une couche semi-isolante CSI en matériau cristallin disposée sur le substrat et en contact avec la couche bloquante CB et la deuxième zone dopée de type n Zn2. La couche semi-isolante CSI empêche le courant de circuler de la jonction verticale JV vers le substrat Sub. La structure cristalline de la couche semi-isolante CSI permet la croissance par épitaxie de couches disposées au-dessus de la couche semi-isolante CSI, et notamment la couche bloquante ainsi que la deuxième zone dopée de type p Zp2. Dans un exemple, la couche semi-isolante CSI est en InP, permettant ainsi l'utilisation à des longueurs d'onde de télécommunication.

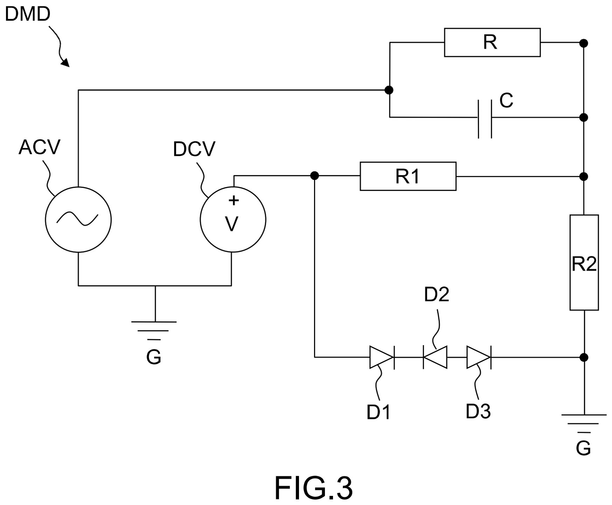

Par exemple, le substrat et la couche semi-isolante CSI sont en InP cristallin, permettant ainsi l'émission à des longueurs d'onde de télécommunication. La figure 3 illustre un exemple de schéma électrique équivalent d'une source lumineuse directement modulée DMD selon le mode de réalisation de la figure 2a. Le schéma électrique équivalent comprend une première diode polarisée en directe D1 qui correspond à la jonction entre la première zone dopée p Zp1 et la troisième zone dopée n Zn3, une diode polarisée en inverse D2 qui correspond à la jonction entre la troisième zone dopée n Zn3 et la troisième zone dopée p Zp3 et une troisième diode polarisée en direct D3 qui correspond à la jonction entre la troisième zone dopée p Zp3 et la deuxième zone dopée n Zn2. Le schéma électrique équivalent comprend également deux générateurs DCV, ACV. Le générateur de courant continu DCV permet d'injecter le courant électrique continu Cdirect dans la jonction horizontale. Le générateur de tension en créneau ACV permet d'injecter la tension oscillant entre deux valeurs prédéterminées dans la jonction verticale JV. La résistance R représente la résistance de la jonction verticale JV et le condensateur C représente la capacité induite par la jonction verticale. Les résistances R1 et R2 représentent la résistance intrinsèque des puits quantiques, la résistance R1 représentant la partie gauche des puits quantiques (avant le contact avec la deuxième zone dopée p Zp2) et la résistance R2 représentant la partie droite des puits quantiques.

Bien que l'invention ait été illustrée et décrite en détail à l'aide d'un mode de réalisation préféré, l'invention n'est pas limitée aux exemples divulgués. D'autres variantes peuvent être déduites par l'homme du métier sans sortir du cadre de protection de l'invention revendiquée.

## Revendications

1. Source lumineuse directement modulée (DMD) comprenant :
- une diode laser dite horizontale (DH) comprenant un substrat (Sub) et une première jonction PIN dite horizontale (JH) s'étendant selon un axe X d'un repère XYZ définissant un plan horizontal XY parallèle audit substrat et un axe vertical Z, la première jonction PIN étant formée d'une zone intrinsèque (Zi) disposée entre une première zone dopée de type p (Zp1) et une première zone dopée de type n (Zn1), la zone intrinsèque (Zi) comprenant un empilement de puits quantiques (PQ) disposés perpendiculairement à l'axe Z ;
la diode laser horizontale étant destinée à être polarisée en direct et configurée pour émettre de la lumière (li) selon l'axe Y lorsqu'un courant électrique continu (Cdirect) est injecté dans la jonction horizontale ;
- une deuxième jonction PIN dite verticale (JV) s'étendant selon l'axe Z et formée de ladite zone intrinsèque (Zi) disposée entre une deuxième zone dopée de type p (Zp2), et une deuxième zone dopée de type n (Zn2) disposée du côté du substrat ;
la jonction verticale (JV) étant destinée à être polarisée en inverse et configurée pour moduler ladite lumière émise par la diode laser horizontale lorsqu'un champ électrique alternatif selon l'axe Z est appliqué à ladite zone intrinsèque (Zi), ladite modulation s'opérant par effet Stark dans les puits quantique ; et
- une couche bloquante (CB) disposée au moins sous la première zone dopée de type p (Zp1) et configurée pour empêcher des fuites de courant entre la première zone dopée de type p (Zp1) et la deuxième zone dopée de type n (Zn2).

2. Source lumineuse directement modulé (DMD) selon la revendication 1, dans lequel la couche bloquante est en matériau isolant ou semi isolant.

3. Source lumineuse directement modulé (DMD) selon la revendication précédente, dans lequel le matériau est de l'InP semi-isolant.

4. Source lumineuse directement modulé (DMD) selon la revendication 1, dans lequel la couche bloquante comprend une troisième zone de type p (Zp3) et une troisième zone de type n (Zn3) formant une diode (DI) configurée pour être polarisée en inverse.

5. Source lumineuse directement modulé (DMD) selon l'une des revendications précédentes, dans lequel la zone intrinsèque (Zi) de la diode laser horizontale (DH) est couplée optiquement à un réseau de rétroaction répartie (DFB).

6. Source lumineuse selon l'une des revendications précédentes dans lequel le substrat est en matériau InP ou GaAs.

7. Source lumineuse directement modulée (DMD) selon l'une des revendications précédentes, la source lumineuse directement modulée (DMD) comprenant en outre une couche semi-isolante (CSI) en matériau cristallin disposée sur le substrat et en contact avec la couche bloquante (CB) et la deuxième zone dopée de type n (Zn2).

8. Source lumineuse directement modulée (DMD) selon la revendication précédente, dans lequel le substrat et la couche semi-isolante sont en matériau InP.
